## Europäisches Patentamt
## European Patent Office
## Office européen des brevets

(19)

(11) Veröffentlichungsnummer : **0 260 500 B1**

(12)

# EUROPÄISCHE PATENTSCHRIFT

(45) Veröffentlichungstag der Patentschrift :
05.06.91 Patentblatt 91/23

(51) Int. Cl.⁵ : **G01R 31/06**

(21) Anmeldenummer : 87112550.6

(22) Anmeldetag : 28.08.87

(54) **Anordnung zur Prüfung dreiphasiger, zum Einsatz in elektrischen Hochspannungsversorgungsnetzen vorgesehener Drosseln.**

(30) Priorität : 12.09.86 DE 3631144

(43) Veröffentlichungstag der Anmeldung :
23.03.88 Patentblatt 88/12

(45) Bekanntmachung des Hinweises auf die
Patenterteilung :
05.06.91 Patentblatt 91/23

(84) Benannte Vertragsstaaten :
AT BE CH DE FR GB LI NL

(56) Entgegenhaltungen :
US-A- 3 775 676
BBC-NACHRICHTEN, Band 64, Nr. 6, 1982,
Seiten 160-170; P. GLANINGER: "Unser Prüffeld für Transformatoren und Drosselspulen"

(73) Patentinhaber : **Siemens Aktiengesellschaft
Wittelsbacherplatz 2
W-8000 München 2 (DE)**

(72) Erfinder : **Müller, Walter, Dr.
Kappelbergsteig 37
W-8540 Schwabach (DE)**
Erfinder : **Stein, Werner, Dr.
Strassenäckerweg 4
W-8500 Nürnberg 60 (DE)**

# Beschreibung

Die Erfindung betrifft eine Anordnung zur Prüfung dreiphasiger, zum Einsatz in elektrischen Hochspannungsversorgungsnetzen vorgesehener Drosseln großer Nennleistung mit zyklisch aufeinanderfolgender Prüfung einzelner Schenkel.

Die Spannungsprüfung dreiphasiger Hochspannungs-Drosselspulen mit abgestufter Isolation, d.h. mit niedrig isoliertem Sternpunkt erfordert eine hohe bereitzustellende Prüfleistung, weil die Stromaufnahme in die Größenordnung des Nennstroms kommt. Dies gilt auch bei Erregung mit erhöhter Frequenz.

Eine Alternative wäre bei der Prüfung eine zyklische einphasige Einspeisung zwischen Phasenklemme und Sternpunkt, die jedoch für eine Langzeitprüfung eine Ausführung der Drosselspule mit Fünfschenkelkernen oder mit wicklungslosen Rückschlußschenkeln gemäß DE-A-28 42 121 erfordert, um über die Kesselwandungen fließende Jochstreuflüsse zu begrenzen. Ein weiterer Nachteil der Einphasenprüfung besteht darin, daß die Prüfspannung Phase gegen Phase dabei gleich der Spannung Phase gegen Erde ist. Dasselbe gilt für die Prüfung mit Schaltstoßspannungen in dieser Schaltung. Da jedoch häufig eine Prüfspannung Phase gegen Phase verlangt wird, die größer ist als das 1,5-fache der Spannung Phase gegen Erde, ist diese Schaltung zur Prüfung von dreiphasigen Hochspannungs-Drosselspulen auch bei Ausführung mit Fünfschenkelkernen nur in Ausnahmefällen anwendbar.

Der Erfindung liegt daher die Aufgabe zugrunde, zur Prüfung von dreiphasigen Drosselspulen großer Nennleistung eine Anordnung zu schaffen, die ohne Gefährdung des Kessels und anderer Bauteile eine zuverlässige Prüfung, insbesondere auch eine Langzeitprüfung mit der 1,5-fachen Nennspannung erlaubt und die die Möglichkeit bietet, die Prüfspannung erforderlichenfalls auf die doppelte Nennspannung zu erhöhen.

Diese Aufgabe wird für Drosselspulen der eingangs genannten Art dadurch gelöst, daß ein Eisenkern der Drosselspule rückschlußschenkellos dreischenklig ausgeführt ist, daß als Prüftransformator ein Dreiphasen-Drehstromtransformator mit elektrisch im Dreieck geschalteten Unterspannungswicklungen und mit elektrisch im Stern geschalteten, mit Wicklungen der Drosselspule elektrisch in Reihe liegenden Oberspannungswicklungen vorgesehen ist und daß der Prüftransformator einphasig erregt ist.

Durch die erfindungsgemäße Kupplung einer zu prüfenden Dreiphasen-Hochspannungsdrosselspule mit einem einphasig erregten Drehstromtransformator wird eine Spannungs- und Flußverteilung in der Drossel zwischen den drei Phasenwicklungen im Verhältnis von +1 : −0,5 : −0,5 erzwungen. Auch bei einer Ausführung der Drosselspule mit einem Dreischenkelkern sind damit Jochstreuflüsse wirksam unterdrückt und die Prüfspannung Phase gegen Phase ist exakt gleich dem 1,5-fachen der Spannung Phase gegen Erde. Gleichzeitig ist dabei der Leistungsbedarf nur halb so groß wie bei dreiphasiger Einspeisung.

Nach zweckmäßigen Weiterbildungen der erfindungsgemäßen Anordnung ist in dem Prüftransformator eine der nicht erregten Unterspannungswicklungen und/oder die dieser zugeordnete Oberspannungswicklung elektrisch kurzgeschlossen, wobei bei Erregung der Wicklungen eines Endschenkels im Prüftransformator jeweils die der erregten Unterspannungswicklung nicht benachbarte Unterspannungs- und/oder Oberspannungswicklung elektrisch kurzgeschlossen ist.

Durch den zuletzt angegebenen Schaltungsaufbau wird zwischen einander benachbarten Wicklungen der Drosselspule eine Spannungs- und Flußverteilung im Verhältnis +1 : −1 erzwungen. Diese Spannungs- und Flußverteilung tritt dabei jeweils zwischen der mit der erregten Transformatorwicklung in Reihe liegenden Drosselspulenwicklung und der den nicht kurzgeschlossenen Transformatorwicklungen zugeordneten Drosselspulenwicklung auf. Bezogen auf die gleiche Prüfspannung Phase gegen Phase beträgt die aufgenommene Leistung wiederum 50% der Drehstromleistung.

Die erfindungsgemäßen Anordnungen erzwingen auch bei der Prüfung mit Schaltstoßspannungen die angegebenen Spannungsverteilungen, so daß auch die hierbei geforderten Spannungspegel ohne Schwierigkeiten erreichbar sind.

Einige Ausführungsbeispiele der erfindungsgemäßen Anordnung sind anhand einer Zeichnung näher erläutert. Es zeigen :

FIG 1 und 2 eine Anordnung aus je einer Drossel und einem Prüftransformator und

FIG 3 bis 5 eine Anordnung aus je einer Drossel und einem Prüftransformator mit mindestens einer kurzgeschlossenen Wicklung.

Einander entsprechende Teile sind in allen Figuren mit den gleichen Bezugszeichen versehen.

Eine Drossel 1 mit drei elektrisch im Stern geschalteten Wicklungen 2 liegt mit den freien Enden ihrer Wicklungen 2 an Hochspannungsklemmen 3. Ein nicht dargestellter Eisenkern der Drossel 1 ist ohne Rückschlußschenkel ausgeführt.

Die Hochspannungsklemmen 3 sind gleichzeitig mit den freien Enden von ebenfalls elektrisch im Stern geschalteten Oberspannungswicklungen 4 eines Drehstromtransformators 5 verbunden. Unterspannungswicklungen 6 des Drehstromtransformators 5 sind elektrisch im Dreieck geschaltet.

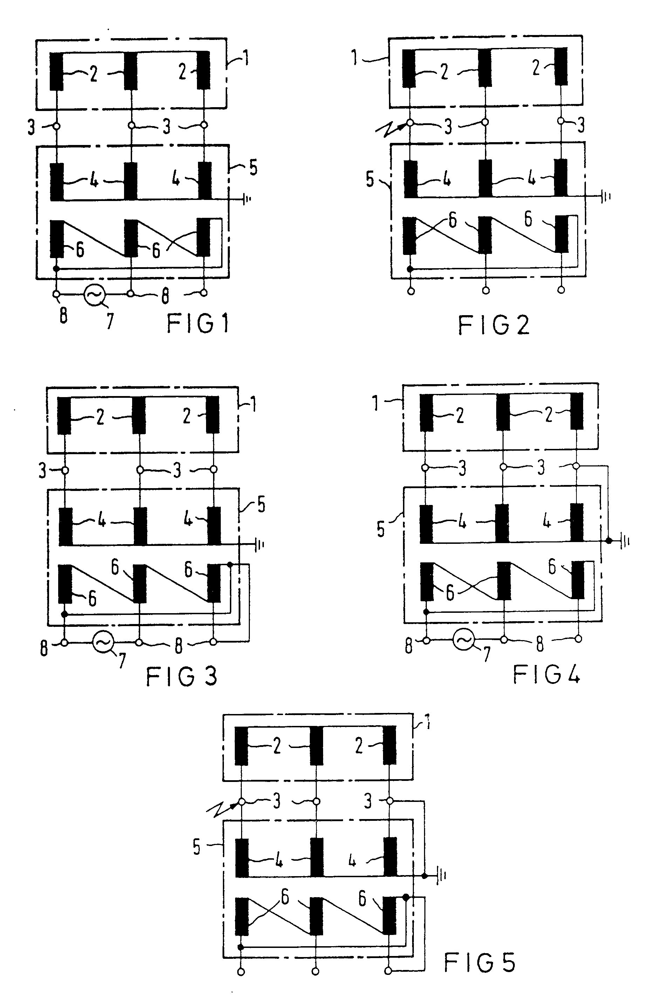

Bei der Anordnung gemäß FIG 1 liegt die Unterspannungswicklung 6 des linken Endschenkels des Drehstromtransformators mit 5 ihren Klemmen 8 an einer Spannungsquelle 7. An den Klemmen 8 der beiden anderen Unterspannungswicklungen 6 des Drehstromtransformators 5 liegt keine Fremdspannung.

Die Spannungsquelle 7 erregt die an sie angeschlossene Unterspannungswicklung 6, die eine Hochspannung in die zugehörige Oberspannungswicklung 4 induziert. Diese Hochspannung liegt an der zugeordneten Hochspannungsklemme 3 und beaufschlagt damit auch die hieran angeschlossene Wicklung 2 in der Drossel 1 mit der vollen Hochspannung. Durch die angegebene Schaltung des Drehstromtransformators 5 liegt an den beiden anderen Hochspannungsklemmen 3 eine nur halb so hohe, jedoch entgegengesetzt gepolte Spannung wie an der linken Hochspannungsklemme 3, so daß die Isolierung zwischen der an der vollen Spannung liegenden Wicklung 2 und der dieser benachbarten Wicklung 2 mit der 1,5-fachen der an der linken Hochspannungswicklung 3 liegenden Spannung beansprucht ist. Dabei nimmt die Drossel 1 bei Nennspannung und Nennstrom in der linken Unterspannungswicklung 6 etwa 50% ihrer Nennleistung auf. Die Spannungsquelle 7 ist daher lediglich für die halbe Nennleistung der Drossel 1 auszulegen.

Bei der Anordnung gemäß FIG 2 ist aus einer nicht dargestellten Prüfeinrichtung ein Spannungsstoß, beispielsweise entsprechend einer Schaltspannung auf die linke Hochspannungsklemme 3 gegeben. Auch die hierdurch auftretende Spannungsverteilung in der Drossel 1 ist durch den mit ihr gekoppelten Drehstromtransformator 5 erzwungen. Durch die Kopplung der Oberspannungswicklungen 4 über den nicht dargestellten Eisenkern des Drehstromtransformators 5 entspricht die Spannungsverteilung wieder der schon oben beschriebenen Verteilung.

Die Isolierung zwischen der direkt mit dem Spannungsstoß belasteten Wicklung 2 und der dieser benachbarten Wicklung 2 ist auch hierbei mit der 1,5-fachen Spannung des Spannungsstoßes beansprucht.

Bei den Anordnungen gemäß FIG 3 und 4 liegt wiederum die Unterspannungswicklung 6 des linken Endschenkels des Drehstromtransformators 5 mit ihren Klemmen 8 an einer Spannungsquelle 7 und wird erregt. Zwischen den Klemmen 8 der beiden anderen Unterspannungswicklungen 6 des Drehstromtransformators 5 liegt wiederum keine Fremdspannung.

Bei der Anordnung gemäß FIG 3 ist die der erregten Unterspannungswicklung 6 räumlich entgegengesetzte Unterspanungswicklung 6 und bei der Anordnung gemäß FIG 4 ist die Oberspannungswicklung auf dem der erregten Unterspannungswicklung 6 entgegengesetzten Eisenkernschenkel elektrisch kurzgeschlossen. Dadurch ist in beiden Fällen die Spannung an der rechten Hochspannungsklemme 3 praktisch auf Erdpotential fixiert.

In dem Drehstromtransformator 5 wird dadurch bei Induktion einer Spannung in die Unterspannungswicklung 6 und die Oberspannungswicklung 4 des linken Eisenkernschenkels eine gleich große aber entgegengesetzt gepolte Spannung (Gegen-EMK) in der Unterspannungswicklung 6 bzw. der Oberspannungswicklung 4 auf dem mittleren Eisenkernschenkel erzwungen. Die linke und die mittlere Hochspannungsklemme 3 führen daher annähernd gleich hohe, jedoch entgegengesetzt gepolte Spannungen. Die Isolierung zwischen der linken und der mittleren Wicklung 2 der Drossel 1 wird daher bei Nennspannung an den Hochspannungsklemmen 3 mit der zweifachen Nennspannung belastet.

Bei der Anordnung gemäß FIG 5 ist sowohl die Unterspannungswicklung 6 als auch die Oberspannungswicklung 4 auf dem rechten Eisenkernschenkel des Drehstromtransformators 5 elektrisch kurzgeschlossen. Auf die linke Hochspannungsklemme 3 wird ein Spannungsstoß gegeben. Auch hierbei wird als Reaktion eine Gegenspannung (Gegen-EMK) allein über den mittleren Schenkel des Drehstromtransformators 5 erzeugt, so daß an der mittleren Hochspannungsklemme 3 eine dem Spannungsstoß etwa gleich große jedoch entgegengesetzt gepolte Spannung anliegt. Auch hierbei wird also wie schon bei den Anordnungen gemäß FIG 3 und 4 die Isolierung zwischen der linken und der mittleren der Wicklungen 2 mit der doppelten Höhe der an die Hochspannungsklemme 3 angelegten Spannung beansprucht.

Die Anordnungen der FIG 1 bis 5 zeigen ausnahmslos die Schaltung zur Prüfung der jeweils linken Wicklung 2 der Drossel 1. Durch zyklisches Vertauschen der Beaufschlagung aus der Spannungsquelle 7 und der elektrischen Kurzschlüsse einer Unterspannungswicklung 6 und/oder einer Oberspannungswicklung 4 werden anschließend in gleicher Weise auch die mittlere und die rechte Wicklung 2 belastet und geprüft. In jedem Fall ist hierbei für die Langzeitprüfung für die Spannungsquelle 7 nur eine Auslegung für die halbe Nennleistung der Drossel 1 erforderlich.

**Ansprüche**

1. Anordnung zur Prüfung dreiphasiger, zum Einsatz in elektrischen Hochspannungsversorgungsnetzen vorgesehener Drosseln (1) großer Nennleistung mit zyklisch aufeinanderfolgender Prüfung einzelner Schenkel, **dadurch gekennzeichnet,**

– daß ein Eisenkern der Drossel (1) rückschlußschenkellos dreischenklig ausgeführt ist,

– daß als Prüftransformator ein Dreiphasen-Drehstromtransformator (5) mit elektrisch im Dreieck geschalteten Unterspannungswicklungen (6) und mit elektrisch im Stern geschalteten, mit Wicklungen (2) der Drossel (1) elektrisch in Reihe liegenden Oberspannungswicklungen (4) vorgesehen ist, und

– daß der Prüftransformator einphasig erregt ist.

2. Anordnung nach Anspruch 1, **dadurch gekennzeichnet,** daß eine der nicht erregten Unterspannungswicklungen (6) und/oder die dieser zugeordnete Oberspannungswicklung (4) des Prüftransformators (5) elektrisch kurzgeschlossen ist.

3. Anordnung nach Anspruch 1 oder 2, **dadurch gekennzeichnet,** daß jeweils die der erregten Unterspannungswicklung (6) nicht benachbarte Unterspannungswicklung (6) und/oder Oberspannungswicklung (4) elektrisch kurzgeschlossen ist.

## Claims

1. Arrangement for testing three-phase coils (1), which are provided for use in electrical high-voltage supply networks and are of great nominal capacity, with cyclically successive testing of individual limbs, characterised in that

an iron core of the coil (1) is constructed with three limbs without return limb, in that

a three-phase rotary current transformer (5) is provided as a testing transformer with low-voltage windings (6), which are electrically delta-connected, and with high-voltage windings (4) which are electrically star-connected and electrically series-connected with windings (2) of the coil (1), and

in that the testing transformer is excited in single phase.

2. Arrangement according to claim 1, characterised in that one of the non-excited low-voltage windings (6) and/or the high-voltage winding (4) of the testing transformer (5) associated with this low-voltage winding is electrically short-circuited.

3. Arrangement according to claim 1 or 2, characterised in that in each case the low-voltage winding (6) which is not adjacent to the excited low-voltage winding (6), and/or high-voltage winding (4), is electrically short-circuited.

## Revendications

1. Dispositif pour tester des bobines d'arrêt triphasées (1), qui sont destinées à être utilisées dans des réseaux électriques de distribution à haute tension et possèdent une puissance nominale élevée, moyennant un contrôle cyclique successif des différentes branches, caractérisé par le fait

– qu'un noyau de fer de la bobine d'arrêt (1) est agencé avec trois branches, sans branche de retour du flux,

– qu'il est prévu, dans un transformateur de contrôle, un transformateur à courant triphasé (5) possédant des enroulements haute tension (6) raccordés électriquement en triangle et des enroulements haute tension (4) raccordés électriquement en étoile et branchés électriquement en série avec des enroulements (2) de la bobine (1), et

– que le transformateur de contrôle est excité en mode monophasé.

2. Dispositif suivant la revendication 1, caractérisé par le fait que l'un des enroulements basse tension (6) non excités et/ou l'enroulement haute tension (4), associé à cet enroulement basse tension, du transformateur de contrôle (5) est court-circuité électriquement.

3. Dispositif suivant la revendication 1 ou 2, caractérisé par le fait que l'enroulement basse tension (6) et/ou l'enroulement haute tension (4), qui n'est pas voisin de l'enroulement basse tension (6) excité, est court-circuité électriquement.

FIG 1

FIG 2

FIG 3

FIG 4

FIG 5